Europäisches Patentamt

European Patent Office

Office européen des brevets

(11) Veröffentlichungsnummer: **0 340 448**
**A2**

(12) # EUROPÄISCHE PATENTANMELDUNG

(21) Anmeldenummer: 89105396.9

(51) Int. Cl.⁴ **G03F 7/20 , G03F 7/02**

(22) Anmeldetag: 23.03.89

(30) Priorität: 30.04.88 DE 3814720

(43) Veröffentlichungstag der Anmeldung:
08.11.89 Patentblatt 89/45

(84) Benannte Vertragsstaaten:
DE FR GB IT

(71) Anmelder: **AEG Olympia Aktiengesellschaft**
**Postfach 960**
**D-2940 Wilhelmshaven(DE)**

(72) Erfinder: **Johannsen, Fred, Dipl.-Ing.**
**Kastanienstrasse 4**
**D-2930 Varel(DE)**

(54) **Verfahren zur Herstellung einer Grundplatte mit durch Ätzen hergestellte Einarbeitung für einen Tintendruckkopf.**

(57) Die Erfindung betrifft ein Verfahren zur Herstellung einer Grundplatte mit in deren Oberflächen eingeätzten Vertiefungen für einen Tintendruckkopf in Tintendruckwerken, wobei die Düsenaustrittsöffnungen mindestens in zwei Reihen angeordnet sind und die Grundplatte aus einem fotoempfindlichen Glasmaterial besteht. Erfindungsgemäß wird die Grundplatte (1) durch zwei chrombedampfte Quarzglasmasken, die spiegelsymmetrisch ausgebildet sind und das gleiche Druckkopf-Layout tragen mit Licht der Wellenlänge belichtet, für welche das Glasmaterial fotoempfindlich ist. Im nächsten Verfahrensschritt wird das Glasmaterial durch Erhitzen auf eine Temperatur wärmebehandelt, bei welcher in den belichteten Bereichen eine Umwandlung der amorphen Glasstruktur in eine keramische Kristallstruktur erfolgt. Danach wird die Grundplatte (1) in eine Ätzmittellösung zum Entfernen der kristallinen Phase des Glasmaterials eingetaucht. Das beschriebene Verfahren für einen Tintendruckkopf mit in zwei Reihen angeordneten Düsenaustrittsöffnungen (7) mit nur einer Grundplatte (1) führt zu hoher Schriftqualität und ist preiswerter als der Aufbau und die Justage von zwei Einzelköpfen.

Fig. 1

## Verfahren zur Herstellung einer Grundplatte mit durch Ätzen hergestellte Einarbeitungen für einen Tintendruckkopf

Die Erfindung betrifft ein Verfahren zur Herstellung einer Grundplatte mit durch Ätzen hergestellte Einarbeitungen für einen Tintendruckkopf in Tintendruckwerken der im Oberbegriff des Patentanspruchs 1 angegebenen Art.

Ein Tintendruckkopf für die Verwendung in Tintendruckwerken enthält im allgemeinen eine einfache Ausstoßöffnung für Tinte, einen Tintenkanal und einen zur Erzeugung der Energie für den Tintenausstoß dienenden Abschnitt, der in einem Teil des Tintenkanals vorgesehen ist. Als Verfahren zur Herstellung eines solchen Tintendruckkopfes war bisher ein Verfahren bekannt, bei dem beispielsweise eine z. B. aus Glas oder Metall hergestellte Platte verwendet wird und in dieser Platte durch eine Bearbeitungsmaßnahme z. B. Schneiden bzw. Spanen der Bearbeitung oder Ätzen eine feine Rinne gebildet wird und die Platte mit der Rinne danach mit einer geeigneten anderen Platte verbunden wird, um dadurch einen Tintenkanal zu bilden.

So ist durch die deutsche Patentschrift 27 58 142 ein Verfahren zur Herstellung einer zum Aufladen von in Tintenstrahldruckern erzeugten Tintentröpfchen vorgesehenen Ladeplatte bekannt, die aus mehreren plattenförmigen Schichten besteht. Da diese Platten aus einem fotoempfindlichen, bei Wärme schmelzenden Material bestehen, können die als Tintenkanäle dienenden Durchgangslöcher leicht eingeätzt werden. Nach Herstellung der einzelnen Platten müssen diese noch durch ein geeignetes Verfahren miteinander verbunden werden. Hierzu ist es erforderlich, daß die in den einzelnen Platten vorhandenen Durchgangslöcher zueinander ausgerichtet werden, was eine entsprechende Sorgfalt erfordert und daher kostenaufwendig ist. Dieses Verfahren ist insbesondere bei Tintendruckköpfen mit in mehreren Reihen angeordneten Tintenaustrittsöffnungen zu kompliziert und zu teuer.

Wegen der für hohe Schriftqualität geforderten Raster 1/180" oder 1/240" ist es bei seriellen Tintenschreibköpfen oftmals nötig, mit mehr als einer Düsenreihe pro Tintenfarbe zu schreiben. Sind die beispielsweise zwei Düsenreihen in zwei unabhängigen Köpfen, so müssen diese zueinander vertikal und horizontal sehr genau justiert werden. Sind sie als spiegelsymmetrische Einzelköpfe gestaltet, so müssen sie mittels Stiftführungen und Passerlöchern miteinander verklebt oder verschweißt werden. Hierbei bestimmt die Stiftführung die erzielbare vertikale Genauigkeit und die Summe der Dickentoleranzen der Kopfplatten die horizontale Rasterqualität.

Es ist die Aufgabe der im Anspruch 1 angegebenen Erfindung, ein Verfahren zur Herstellung einer Grundplatte mit in deren Oberflächen durch Ätzen erstellte Einarbeitungen für einen Tintendruckkopf in Tintendruckwerken zu schaffen, das einen einfachen Aufbau eines Tintendruckkopfes mit in mehreren Reihen angeordneten Düsenaustrittsöffnungen ermöglicht, wobei eine hohe Schriftqualität stets gewährleistet ist. Diese Aufgabe wird durch die im Patentanspruch 1 gekennzeichnete Erfindung vorteilhaft gelöst.

Da die Tintenkanäle, Tintenkammern und Düsenaustrittsöffnungen für z. B. die Düsenaustrittsöffnungen in zwei Reihen aufweisenden Tintendruckköpfen sich auf entgegengesetzten Seiten einer einzigen Grundplatte befinden und gleichzeitig in einem Ätzvorgang eingeätzt werden, entfällt die bei in zwei getrennten Platten angeordneten Einarbeitungen erforderliche Justage. Außerdem gewährleistet das erfindungsgemäße Verfahren eine gleichmäßige Tiefe aller Düsenaustrittsöffnungen, so daß immer gleichmäßige Tintentröpfchen erzeugbar sind.

Weitere Merkmale der Erfindung sind den Unteransprüchen zu entnehmen.

Die Erfindung ist nachstehend anhand von in den Figuren veranschaulichten Ausführungsbeispielen beschrieben. Es zeigt:

Figur 1 die Grundplatte und die Maskenplatten in schaubildlicher Darstellung,

Figur 2 eine Draufsicht auf die geätzte Grundplatte,

Figur 3 eine Frontansicht auf die geätzte Grundplatte,

Figur 4 eine Einzelheit aus Figur 3 und

Figur 5 ein Schliffbild durch einen Tintendruckkopf mit in zwei Reihen angeordneten Düsenaustrittsöffnungen.

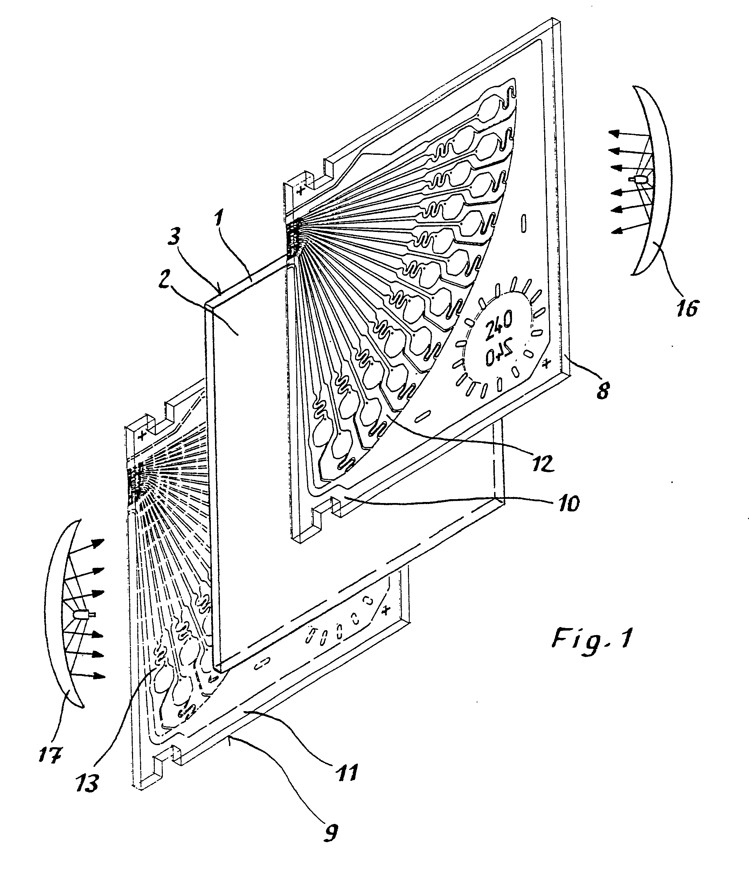

Die Figur 1 zeigt eine Grundplatte 1 aus einem fotoempfindlichen Glasmaterial, in deren Oberflächen 2, 3 Tintenvorratskammern 4, Tintendruckkammern 5, Tintenkanäle 6 und Düsenaustrittsöffnungen 7 eingeätzt werden sollen. Als fotoempfindliches Glas kann ein Substratmaterial verwendet werden, wie es beispielsweise unter dem Handelsnamen Foto-Ceram von der amerikanischen Firma Corning Glass Works oder Foturan-Glas von der deutschen Firma Schott Glaswerke vertrieben wird.

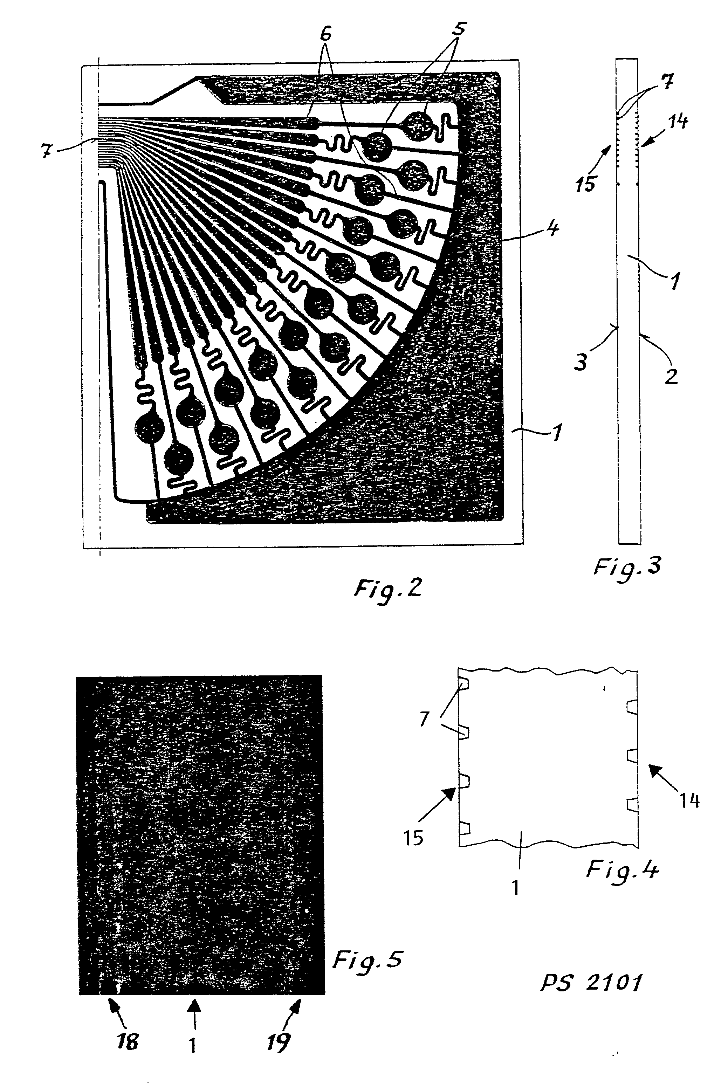

Beiderseits der Grundplatte 1 ist je eine Quarzglasplatte 8, 9 angeordnet, die auf ihren der Grundplatte 1 abgewendeten Oberflächen 10, 11 je eine durch Chrombedampfung aufgebrachte Maske 12, 13 aufweisen. Diese Masken tragen das in Figur 1 dargestellte Tintendruckkopf-Layout. Die beiden chrombedampften Quarzglasmasken 12, 13 sind spiegelsymmetrisch ausgebildet und derart versetzt zueinander angeordnet, daß die zu bildenden Düsenaustrittsöffnungen 7 der einen Reihe 14 mittig zu den Düsenaustrittsöffnungen 7 der anderen Reihe 15 angeordnet sind, siehe Figuren 3 und 4.

Die einzelnen Schritte des erfindungsgemäßen Verfahrens werden im folgenden erläutert. Zunächst wird die Grundplatte 1 durch die beiden chrombedampften Quarzglasmasken 12, 13 mit von zwei Lichtquellen 16, 17 ausgestrahltem Licht der Wellenlänge belichtet, für welche das Quarzglasmaterial der Grundplatte 1 fotoempfindlich ist. Die beiden Lichtquellen 16, 17 liefern vorzugsweise kolliminiertes Licht und bestehen aus Quecksilber-Xenon-Lampen. Die Öffnungen in den Masken 12, 13 entsprechen den endgültigen Größen der Öffnungen bzw. der Ausnehmungen in der Grundplatte 1. Durch das Belichten werden Nukleationsstellen innerhalb des Glasmaterials entwickelt, an denen später ein Kristallwachstum auftritt. Nach dieser Belichtung erfolgt eine Wärmebehandlung der Grundplatte durch Erhitzen auf eine Temperatur, bei welcher in den belichteten Bereichen eine Umwandlung der amorphen Glasstruktur in eine keramische Kristallstruktur erfolgt. Die sich in den exponierten Bereichen bildende kristalline Substanz ist als "Foto-Opal" bekannt. Bei diesem Verfahrensschritt wird das Glas auf die ihm eigene kritische Temperatur gebracht und bei dieser Temperatur solange gehalten, bis der Kristallisationsvorgang beendet ist. Beispielsweise werden vom Hersteller des Foto-Ceram-Glases 592° Celsius und 30 Minuten Umwandlungszeit angegeben.

Der nächste Schritt des Verfahrens umfaßt das Eintauchen der Grundplatte 1 in eine geeignete Ätzlösung, von welcher das kristalline Foto-Opal-Glas wesentlich stärker angegriffen wird als das Foto-Form-Glas. Als Foto-Form-Glas wird das unbelichtete Glas bezeichnet. Eine geeignete Ätzlösung ist eine 12 %ige Lösung von Flußsäure in Wasser. Die Tiefe der in die Oberflächen 2, 3 der Grundplatte 1 eingeätzten Vertiefungen hängt von der Zeit der Ätzung ab. In der Figur 2 ist eine Grundplatte 1 nach dem Ätzvorgang dargestellt.

Die von den Lichtquellen 16, 17 ausgestrahlte Lichtmenge wird so ausgewählt, daß das Licht nicht durch die Grundplatte 1 hindurchgeht. Hierdurch wird vermieden, daß die Ätzungen immer nur von den belichteten Oberflächen aus erfolgen können.

Vor dem Ätzvorgang werden die Grundplatten 1 noch geschliffen und poliert. Danach wird je eine Membranplatte 18, 19 auf die Oberflächen 2, 3 der Grundplatte 1 angeordnet. Diese Befestigung der Membranplatten 18, 19 mit der Grundplatte 1 kann durch Kleben oder auch durch einen Sintervorgang erfolgen.

In der Figur 5 ist ein Schliffbild durch den Düsenbereich eines Tintendruckkopfes dargestellt, wobei die Düsenaustrittsöffnungen 7 vor den dunklen Bereichen, die die kristalline Form enthalten, zu erkennen. Die dunklen Streifen laufen mit zunehmender Tiefe aus. Die hellen Streifen in Figur 5 betreffen die nicht belichteten Stellen in der Grundplatte 1, die schwer ätzbar sind.

Die zum Belichten verwendeten chrombedampften Quarzglasmasken sind spiegelsymmetrisch ausgebildet und werden in einem Maskenrahmen so eingespannt, daß sie zueinander justierbar sind. Durch im Layout enthaltene Justiermarken ist der Düsenversatz auf weniger als ± 001 mm einstellbar. Alle Tintendruckköpfe, die derart belichtete Grundplatten 1 erhalten, weisen diesen geringen Rasterfehler auf. Es gibt keine fertigungsbedingte Streuung. Der horizontale Rasterabstand wird durch die Ätztiefe und das Schleifmaß der Grundplatte 1 bestimmt.

Da die Düsenreihen gleichzeitig geätzt werden, ist ein unterschiedlicher Düsendurchmesser beider Reihen beim Ätzen ausgeschlossen.

## Ansprüche

1. Verfahren zur Herstellung einer Grundplatte mit in deren Oberflächen durch Ätzen eingearbeitete Tintendruckkammern, Tintenkanäle und Düsenaustrittsöffnungen für einen Tintendruckkopf in Tintendruckwerken, wobei die Düsenaustrittsöffnungen mindestens in zwei Reihen angeordnet sind, und die Grundplatte aus einem fotoempfindlichen Glasmaterial besteht, **gekennzeichnet durch** folgende Schritte:

a) Belichten der Grundplatte (1) durch zwei chrombedampfte Quarzglasmasken, die spiegelsymmetrisch ausgebildet sind und das gleiche Druckkopf-Layout tragen, mit Licht der Wellenlänge, für welche das Glasmaterial fotoempfindlich ist.

b) Wärmebehandeln des Glasmaterials durch Erhitzen auf eine Temperatur, bei welcher in den belichteten Bereichen eine Umwandlung der amorphen Glasstruktur in eine keramische Kristallstruktur erfolgt.

c) Eintauchen der Grundplatte (1) in eine Ätzmittellösung zum Entfernen der kristallinen Phase des Materials der Grundplatte (1).

2. Verfahren nach Anspruch 1, **dadurch gekennzeichnet,** daß das Belichten der beiden Seiten der Grundplatte (1) über die beiden Quarzglasmasken (12, 13) gleichzeitig erfolgt.

3. Verfahren nach Anspruch 2, **dadurch gekennzeichnet,** daß die Masken aus chrombedampften Quarzglasmasken (12, 13) bestehen.

4. Verfahren nach einem der vorhergehenden Ansprüche, **dadurch gekennzeichnet,** daß die beiden Quarzglas masken (12, 13) beim Belichtungsvorgang versetzt voneinander gelagert sind, derart, daß jede Düsenaustrittsöffnung (7) einer Reihe (14) zu zwei Düsenaustrittsöffnungen (7) der anderen Reihe (15) mittig liegt.

5. Verfahren nach einem der vorhergehenden Ansprüche, **dadurch gekennzeichnet,** daß das Belichten des Glasmaterials mittels UV-Licht erfolgt.

Fig. 1

PS 2101

Fig.2

Fig.3

Fig.5

Fig.4

PS 2101